# EUROPÄISCHE PATENTANMELDUNG

(11) **EP 1 713 316 A2**
(43) Veröffentlichungstag der Anmeldung: **18.10.2006**
(21) Anmeldenummer: 06112210.7
(22) Anmeldetag: 04.04.2006
(51) Int. Cl.: H05K 13/04, H05K 13/02

(54) **Zuführeinrichtung zum zuführen elektrischer Bauteile , zugehörige Schneidevorrichtung, Bestückautomat zum Bestücken von Substraten mit elektrischen Bauteilen und entsprechendes Bestücksystem**

(30) Priorität: 13.04.2005 DE 102005017015
(71) Anmelder: SIEMENS AKTIENGESELLSCHAFT, 80333 München (DE)
(72) Erfinder: Berndl, Erhard, 82008, Unterhaching (DE); Mehdianpour, Mohammad, 81829, München (DE)

(57) **Zusammenfassung**

Eine Zuführeinrichtung (5) zum Zuführen von in Vertiefungen (14) eines Bauteilgurts (13) gelagerten elektrischen Bauteilen für einen Bestückautomat (2) umfasst einen Transportmechanismus (16), mittels dem der Bauteilgurt (13) entlang eines Transportwegs (15) in der Zuführeinrichtung (5) transportierbar ist, und einen bewegbaren Schneidekörper (19) zum Durchtrennen des Bauteilgurts (13), welcher an einer Stelle entlang des Transportweges (15) angeordnet und mit einer externen Antriebseinrichtung (9) koppelbar ist, mittels welcher der bewegbare Schneidekörper (19) in einer Schneidrichtung in eine Schneideposition bewegbar ist, in der der bewegliche Schneidekörper (19) in Zusammenwirken mit einem Gegenschneidekörper (20) den Bauteilgurt (13) durchtrennt.

## Beschreibung

Die Erfindung betrifft eine Zuführeinrichtung zum Zuführen elektrischer Bauteile, eine Schneidevorrichtung für die Zuführeinrichtung, einen geeignet angepassten Bestückautomaten sowie ein Bestücksystem zum Bestücken von Substraten mit elektrischen Bauteilen.

Bei einem Bestückautomaten zum Bestücken von Substraten mit elektrischen Bauteilen werden die Bauteile durch am Bestückautomaten angeordnete Zuführeinrichtungen bereitgestellt. Die elektrischen Bauteile sind häufig in taschenartigen Vertiefungen eines entsprechend langen Bauteilgurtes magaziniert. Der Bauteilgurt wird mittels eines Transportmechanismus der Zuführeinrichtung durch die Zuführeinrichtung transportiert, wobei die Bauteile an einer Abholposition von einem Bestückkopf des Bestückautomaten aus den Vertiefungen entnommen werden. Der leere Gurt verlässt die Zuführeinrichtung an einer geeigneten Stelle. Häufig besteht die Notwendigkeit, die leeren Bauteilgurte nach Austritt aus der Zuführeinrichtung in bestimmten Abständen zu schneiden, um den Restmüll in eine handhabbare Form zu bringen.

Aus der Offenlegungsschrift DE 19604608 ist eine Schneidevorrichtung für einen Bestückautomaten bekannt, welche sich über die gesamte Breite der am Bestückautomaten angeordneten Zuführeinrichtungen erstreckt und mittels eines einzigen langen und beweglichen Schneidmessers die Bauteilgurte abschneidet. Das Schneiden der Bauteilgurte erfolgt durch eine scherenartige Bewegung des beweglichen Schneidmessers gegen eine entsprechend lang ausgebildete Schneidkante. Bei dieser Schneideeinrichtung kann es zu Störungen kommen, wie beispielsweise dem Verklemmen von Bauteilgurten zwischen dem Schneidmesser und der Schneidkante.

Es ist deshalb die Aufgabe der vorliegenden Erfindung, eine Zuführeinrichtung, eine Schneidevorrichtung, einen Bestückautomaten sowie ein Bestücksystem bereitzustellen, welche eine höhere Betriebssicherheit aufweisen.

Diese Aufgabe wird durch die Zuführeinrichtung, die Schneidevorrichtung, den Bestückautomaten und durch das Bestücksystem gemäß den unabhängigen Ansprüchen gelöst.

Die Zuführeinrichtung gemäß dem unabhängigen Anspruch 1 eignet sich zum Zuführen eines Bauteilgurts mit taschenartigen Vertiefungen zur Aufnahme von elektrischen Bauteilen. Der Bauteilgurt wird mittels eines Transportmechanismus entlang eines Transportweges in der Zuführeinrichtung bewegt. Entlang des Transportweges weist die Zuführeinrichtung einen bewegbaren Schneidekörper auf, welcher in einer Schneidrichtung beweglich gelagert ist. Der bewegbare Schneidekörper ist mit einer externen Antriebseinrichtung, welche nicht der Zuführeinrichtung zugeordnet ist, derart koppelbar, dass er mittels der Antriebseinrichtung in der Schneidrichtung in eine Schneidposition bewegbar ist, in der der bewegbare Schneidekörper durch entsprechendes Zusammenwirken mit einem Gegenschneidekörper einen in der Zuführeinrichtung transportierten Bauteilgurt in der Schneideposition durchtrennt. Die Schneidkante des Schneidekörpers kann deshalb relativ schmal ausgebildet werden, maximal so breit wie der breiteste, durch die Zuführeinrichtung geführte Bauteilgurt. Ferner kann der schmal ausgebildete Schneidekörper individuell an der Zuführeinrichtung durch eine Führungseinrichtung geführt werden, wodurch sich die Präzision und die Zuverlässigkeit des Schneidevorgangs deutlich erhöhen. Ein Verbiegen des Schneidekörpers sowie ein Verklemmen des Bauteilgurts zwischen Scheidekörper und Gegenschneidekörper kann bei dem schmalen, präzise geführten Schneidekörper weitgehend ausgeschlossen werden. Dadurch, dass die erfindungsgemäße Zuführeinrichtung nicht über einen eigenen Antriebsmechanismus für den Schneidekörper verfügt, sondern konstruktiv derart ausgestaltet ist, dass der Schneidekörper über eine externe Antriebseinrichtung bewegbar ist, können weiterhin Kosten reduziert und die Wirtschaftlichkeit erhöht werden.

In einer Ausgestaltung gemäß dem Anspruch 2 ist auch der Gegenschneidekörper an der Zuführeinrichtung befestigt. Dadurch, dass sowohl der bewegbare Schneidekörper als auch der Gegenschneidekörper an der Zuführeinrichtung vorhanden sind, kann an allen Orten, an denen eine entsprechende Antriebseinrichtung für den bewegbaren Schneidekörper vorhanden ist, ein Schneidevorgang durchgeführt werden kann. So kann beispielsweise der Schneidevorgang am Bestückautomaten oder auch an einem Rüstplatz für die Zuführeinrichtung vorgenommen werden, sofern sich an beiden Orten entsprechende Antriebseinrichtungen befinden. Dadurch wird die Flexibilität der Zuführeinrichtung erhöht.

Als Alternative zur Ausgestaltung gemäß Anspruch 2 kann der Gegenschneidekörper gemäß Anspruch 3 auch mit dem Bestückautomaten fest verbunden sein. Folglich muss der bewegbare Schneidekörper derart an der Zuführeinrichtung angeordnet sein, dass er in einem Zustand, in dem die Zuführeinrichtung an dem Bestückautomaten angekoppelt ist, dem Gegenschneidekörper gegenüber steht, sodass er zum Schneiden des Bauteilgurts mit diesem entsprechend in Wechselwirkung treten kann. Der Gegenschneidekörper muss dabei nicht unbedingt am Bestückautomaten selbst, sondern kann auch an einem Transportwagen für die Zuführeinrichtungen oder an einem entsprechenden Rüstplatz vorgesehen sein. Dadurch, dass der Gegenschneidekörper nicht der Zuführeinrichtung zugeordnet ist, werden nur sehr geringe Kräfte beim Schneiden auf die Zuführeinrichtung übertragen.

Gemäß der Ausgestaltung nach Anspruch 4 ist die Antriebseinrichtung für den beweglichen Schneidekörper dem Bestückautomaten zugeordnet, wobei die Antriebseinrichtung entweder unmittelbar am Bestückautomaten selbst befestigt ist, oder auch an einem zum Bestückautomaten gehörenden Transportwagen für die Zuführeinrichtungen vorgesehen sein kann.

Der bewegliche Schneidekörper kann nach Anspruch 5 federnd gelagert sein, wobei die elastische Kraft des Federelements den Schneidekörper in eine Ruheposition drängt, in der der Bauteilgurt frei durch die Zuführeinrichtung transportierbar ist. Somit muss die Antriebseinrichtung nur zum Zwecke des Schneidens aktiviert werden, wobei der Schneidekörper ansonsten durch die elastische Kraft in der Ruheposition verbleibt. Dadurch ergibt sich eine einfache und energiesparende Konstruktion.

In bestimmten Anwendungsfällen ist ein Schneiden der Bauteilgurte unerwünscht. Gemäß der Ausgestaltung nach Anspruch 6 ist es deshalb möglich, für jede Zuführeinrichtung individuell den bewegbaren Schneidekörper vom Gehäuse der Zuführeinrichtung abzunehmen, wodurch ein Schneiden des Bauteilgurts sehr leicht unterbunden werden kann. Dadurch, dass dieses für jede Zuführeinrichtung individuell möglich ist, ergibt sich eine hohe Flexibilität.

In einer konkreten Ausgestaltung gemäß Anspruch 7 umfasst die Zuführeinrichtung am Gehäuse ein Führungselement, welches den beweglichen Schneidekörper hält und in der Schneidrichtung führt. Dabei ist das Führungselement so ausgebildet, dass der bewegliche Schneidekörper einfach aus dem Führungselement entnehmbar bzw. herausziehbar ist.

Bestimmte Bauteiltypen, insbesondere tantalhaltige Bauteile, sollten aus Sicherheitsgründen nicht von dem schlagartig bewegten Schneidekörper getroffen werden. Um dies zu verhindern, ist der bewegliche Schneidekörper gemäß Anspruch 8 an einer bestimmten Position entlang eines Transportweges angeordnet, so dass ein bestimmter Bauteilgurttyp immer zwischen den taschenartigen Vertiefungen, in denen sich die Bauteile befinden, durchtrennt wird. Dadurch wird die Betriebssicherheit der Zuführeinrichtung erhöht.

Eine Schneidevorrichtung gemäß dem unabhängigen Anspruch 9 kann lösbar an eine Zuführeinrichtung angebracht werden. Die Zuführeinrichtung umfasst dabei einen Transportmechanismus, mittels dem ein Bauteilgurt mit Vertiefungen zur Aufnahme von elektrischen Bauteilen entlang eines Transportweges in der Zuführeinrichtung transportierbar ist. Nach der Entnahme der Bauteile an einer Abholposition durch einen Bestückkopf eines Bestückautomaten verlässt der leere Bauteilgurt die Zuführeinrichtung in einem Austrittsbereich. Die Schneidevorrichtung umfasst ein Schneidgehäuse mit einer Eintritts- und einer Austrittsöffnung, wobei beide Öffnungen über einen im Schneidgehäuse verlaufenden Führungskanal für den Bauteilgurt miteinander verbunden sind. Entlang des Führungskanals, beispielsweise im Bereich der Austrittsöffnung, weist die Schneidevorrichtung einen in einer Schneidrichtung bewegbaren Schneidekörper und einen stationären Gegenschneidekörper auf. Die Schneidevorrichtung ist so an der Zuführeinrichtung anbringbar, dass der Führungskanal eine Verlängerung des Transportweges darstellt und der Bauteilgurt nach Verlassen der Zuführeinrichtung im Austrittsbereich unmittelbar über die Eintrittsöffnung in den Führungskanal der Schneidevorrichtung übergeht und diese über die Austrittsöffnung verlässt. Der bewegbare Schneidekörper ist mit einer externen Antriebseinrichtung koppelbar, mittels welcher er in der Schneidrichtung in eine Schneidposition bewegbar ist. In der Schneidposition tritt der Schneidekörper derart mit dem Gegenschneidekörper in Wechselwirkung, dass ein Bauteilgurt, welcher die Schneidevorrichtung durch die Austrittsöffnung verlässt, durchtrennt wird. Die Schneidevorrichtung bietet den Vorteil, dass sie für Zuführeinrichtungen, welche über eine derartige Schneidevorrichtung nicht verfügen, einfach nachrüstbar ist. Durch die lösbare Befestigung der Schneidevorrichtung an der Zuführeinrichtung kann die Schneideeinrichtung auch einfach und schnell abmontiert werden, was insbesondere bei Bauteilgurten, welche nicht geschnitten werden sollen, vorteilhaft ist.

Gemäß einer Ausgestaltung der Schneidevorrichtung nach Anspruch 10 sind der Schneidekörper und der Gegenschneidekörper derart angeordnet, dass sie einen bestimmten Bauteilgurttyp immer zwischen den taschenartigen Vertiefungen durchtrennen. In dem Fall, dass der Schneidekörper und der Gegenschneidekörper gemäß Anspruch 11 unmittelbar an der Austrittsöffnung der Schneidevorrichtung vorgesehen sind, wird dies dadurch erreicht, dass die Länge des Führungskanals derart ausgelegt ist, dass beim taktweisen Vorschub des Bauteilgurts immer der zwischen den Vertiefungen liegende Teil des Bauteilgurts an der Schnittlinie des Schneidekörpers stoppt. Dadurch kann vermieden werden, dass sicherheitskritische Bauteile, wie beispielsweise tantalhaltige Bauteile, durch den schlagartig bewegten Schneidekörper getroffen werden. Es ist jedoch auch denkbar, dass der Schneidekörper und der Gegenschneidekörper an einer anderen Position entlang des Führungskanals, welche nicht unbedingt an der Austrittsöffnung sein muss, vorgesehen sind, derart, dass ein bestimmter Bauteilgurttyp immer zwischen den taschenartigen Vertiefungen durchtrennt wird.

Anspruch 12 betrifft eine Zuführeinrichtung mit einer entsprechend daran angebrachten Schneidevorrichtung gemäß den Ansprüchen 9 bis 11. Die Vorteile einer derartigen Zuführeinrichtung gelten entsprechend.

An einen Bestückautomaten gemäß dem Anspruch 13 sind in einem Zuführbereich mehrere Zuführeinrichtungen nach einem der Ansprüche 1 bis 8, oder 12 ankoppelbar. Ferner umfasst der Bestückautomat mindestens eine Antriebseinrichtung, mittels der der bewegbare Schneidekörper mindestens einer der Zuführeinrichtungen im gekoppelten Zustand bewegbar ist.

Die Antriebseinrichtung des Bestückautomats kann gemäß Anspruch 14 derart ausgebildet ist, dass damit die bewegbaren Schneidekörper mehrerer Zuführeinrichtungen gemeinsam bewegbar sind. Dadurch ist es nicht nötig, für sämtliche Zuführeinrichtungen einen eigenen Antrieb für den Schneidekörper vorzusehen. Dadurch ergibt sich eine preisgünstige Ausgestaltung des Bestückautomaten und eine einfachere Konstruktion.

Gemäß den Ausgestaltungen des Bestückautomaten nach den Ansprüchen 15 und 16 wird die Antriebseinrichtung dadurch realisiert, dass eine sich über die gesamte Breite des Zuführbereichs erstreckende, beweglich gelagerte Antriebsleiste durch zwei an den jeweiligen Enden der Antriebsleiste vorgesehenen Aktuatoren bewegt wird. Bei dieser Ausgestaltung werden die beweglichen Schneidekörper der Zuführeinrichtungen mittelbar oder unmittelbar durch die Antriebsleiste in Schneidrichtung bewegt. Diese Ausgestaltung ergibt eine einfache und zuverlässige Realisierung der Antriebseinrichtung.

Für das Bestücksystem gemäß Anspruch 17 mit dem Bestückautomaten nach einem der Ansprüche 13 bis 16 und mehreren daran gekoppelten Zuführeinrichtungen nach einem der Ansprüche 1 bis 8, oder 12 gelten die genannten Vorteile analog.

Im Folgenden wird die Erfindung anhand von Ausführungsbeispielen unter Bezug auf die beigefügten Zeichnungen näher erläutert. In den Zeichnungen sind:
Figur 1 eine schematische Ansicht eines Ausführungsbeispiels des Bestücksystems, umfassend einen Bestückautomaten und mehrere Zuführeinrichtungen,
Figur 2 eine schematische Querschnittansicht eines Ausführungsbeispiels der erfindungsgemäßen Zuführeinrichtung,
Figur 3 ein vergrößerter Ausschnitt der in Figur 2 gezeigten Zuführeinrichtung,
Figur 4 eine Rückansicht des Führungselements des beweglichen Schneidekörpers,
Figur 5 ein Ausführungsbeispiel eines beweglichen Schneidekörpers,
Figur 6 eine schematische Darstellung der gefederten Lagerung des beweglichen Schneidekörpers,
Figur 7 ein vergrößerter Ausschnitt der Zuführeinrichtung, wobei sich der bewegliche Schneidekörper in der Ruheposition befindet,
Figur 8 ein vergrößerter Ausschnitt der Zuführeinrichtung, wobei sich der bewegliche Schneidekörper in der Schneideposition befindet,
Figur 9 ein Ausführungsbeispiel der erfindungsgemäßen Schneidevorrichtung, welche an einer Zuführeinrichtung lösbar befestigt ist,
Figur 10 ein Ausführungsbeispiel der erfindungsgemäßen Zuführeinrichtung, wobei sich der Gegenschneidekörper nicht an der Zuführeinrichtung angebracht ist, und
Figur 11 eine schematische Darstellung eines Ausführungsbeispiels der Antriebseinrichtung für den beweglichen Schneidekörper.

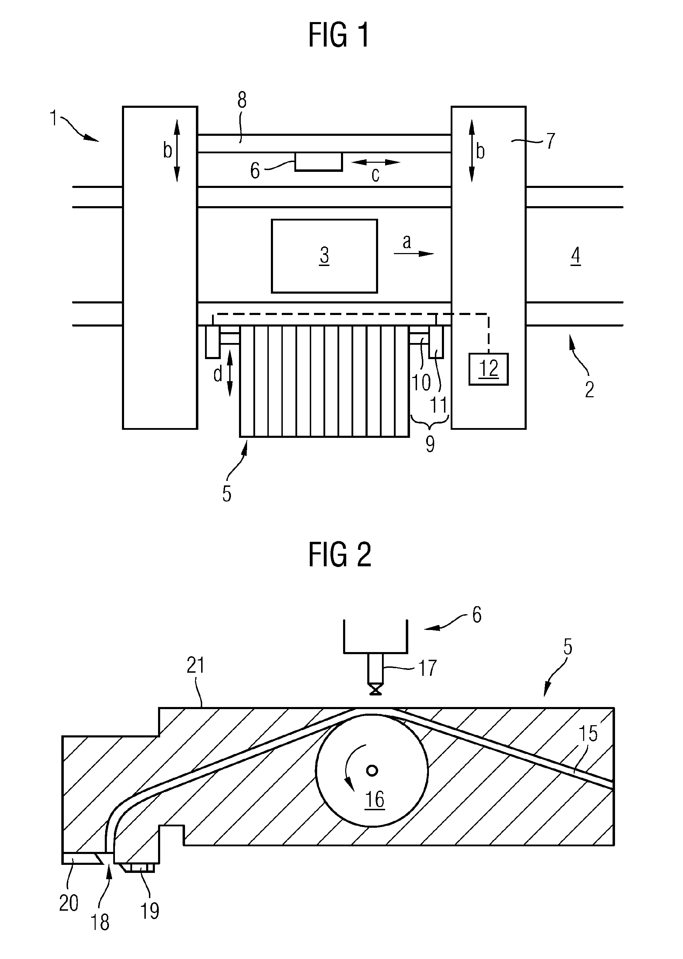

In Figur 1 ist ein Ausführungsbeispiel eines erfindungsgemäßen Bestücksystems 1 schematisch dargestellt. Das Bestücksystem 1 umfasst einen Bestückautomaten 2, auf dem ein zu bestückendes Substrat 3 in einer Transportrichtung (Pfeil a) entlang einer Transportstrecke 4, beispielsweise eines Transportbandes, zu einem Bestückplatz des Bestückautomaten 2 hin transportiert, dort bestückt und von dort wieder wegtransportiert werden. Seitlich entlang der Transportstrecke 4 sind in einem Zuführbereich mehrere Zuführeinrichtungen 5 an den Bestückautomaten 2 gekoppelt. Die Zuführeinrichtungen 5 dienen der Zufuhr der auf dem Substrat 3 zu platzierenden Bauteile. Der Bestückautomat 2 weist ferner einen Bestückkopf 6 auf, welcher mittels eines zweidimensional beweglichen Positioniersystems zwischen den Zuführeinrichtungen 5 und dem Bestückplatz bewegbar ist, um Bauteile von den Zuführeinrichtungen 5 aufzunehmen und sie auf dem Substrat 3 abzusetzen. Im Ausführungsbeispiel besteht das Positioniersystem aus zwei portalartigen Querträgern 7, welche die Transportstrecke 4 brückenartig überspannen, sowie einem Längsträger 8, welcher an seinen Enden an den Querträgern 7 bewegbar gelagert ist und, beispielsweise mittels eines Linearmotors, quer zur Transportrichtung verfahrbar ist (Pfeile b). Der Bestückkopf 6 ist, beispielsweise mittels eines weiteren Linearmotors, parallel zur Transportrichtung entlang des Längsträgers verfahrbar (Pfeil c).

Der Bestückautomat 2 umfasst ferner eine Antriebseinrichtung 9, welche sich über alle im Zuführbereich an den Bestückautomaten 2 angekoppelten Zuführeinrichtungen 5 erstreckt und eine Antriebsleiste 10 sowie zwei an den Enden der Antriebsleiste 10 angeordnete Aktuatoren 11 aufweist. Die Antriebseinrichtung 9 ist über elektrische Leitungen, welche in Figur 1 durch gestrichelte Linien dargestellt sind, mit einer Steuereinrichtung 12 des Bestückautomaten 2 gekoppelt. Der genaue Aufbau und die Funktionsweise der Antriebseinrichtung 9 werden im Verlauf der weiteren Beschreibung näher erläutert.

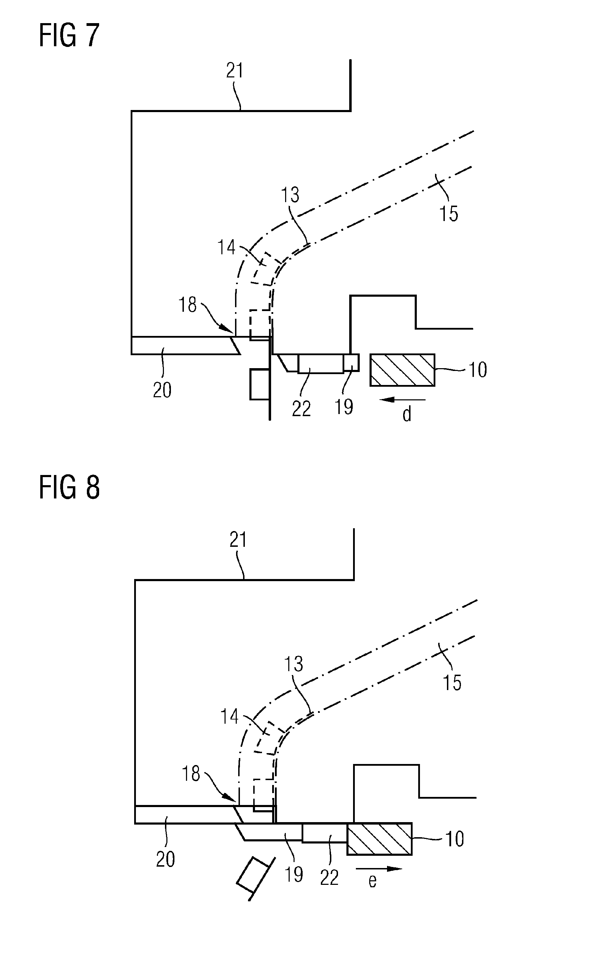

Figur 2 ist eine schematische Querschnittsansicht eines Ausführungsbeispiels einer an dem Bestückautomaten 2 aus Figur 1 angekoppelten Zuführeinrichtung 5. Die gezeigte Zuführeinrichtung 5 eignet sich zum Fördern von Bauteilgurten (siehe Fig. 7), welche taschenartige Vertiefungen 14 aufweisen, in denen elektrische Bauteile gelagert sind. In der Zuführeinrichtung 5 ist der Bauteilgurt 13 entlang eines Transportweges 15 mittels eines Transportmechanismus 16 transportierbar. Der Transportmechanismus 16 besteht, wie in Figur 2 andeutungsweise dargestellt, aus einem elektrisch angetriebenen Transportrad, welches bekanntermaßen an seinem Umfang Transportstifte aufweist, um in entsprechende Perforationen am Bauteilgurt 13 einzugreifen und diesen so entlang des Transportweges 15 zu befördern. Der Bauteilgurt 13 wird dabei in vorgegebenen Zeitabständen schrittweise um eine exakt definierte Vorschublänge vorwärts transportiert. Dabei werden die elektrischen Bauteile mittels eines Greifers 17 am Bestückkopf 6 an einer Abholposition der Zuführeinrichtung 5 aus den taschenartigen Vertiefungen 14 entnommen. Der leere Gurt wird weiter entlang des Transportweges 15 transportiert und verlässt die Zuführeinrichtung 5 in einem Austrittsbereich 18. Im Austrittsbereich 18 weist die Zuführeinrichtung 5 einen bewegbaren Schneidekörper 19 sowie einen Gegenschneidekörper 20 auf, welche beide an der Außenseite eines Gehäuses 21 der Zuführeinrichtung 5 angeordnet sind.

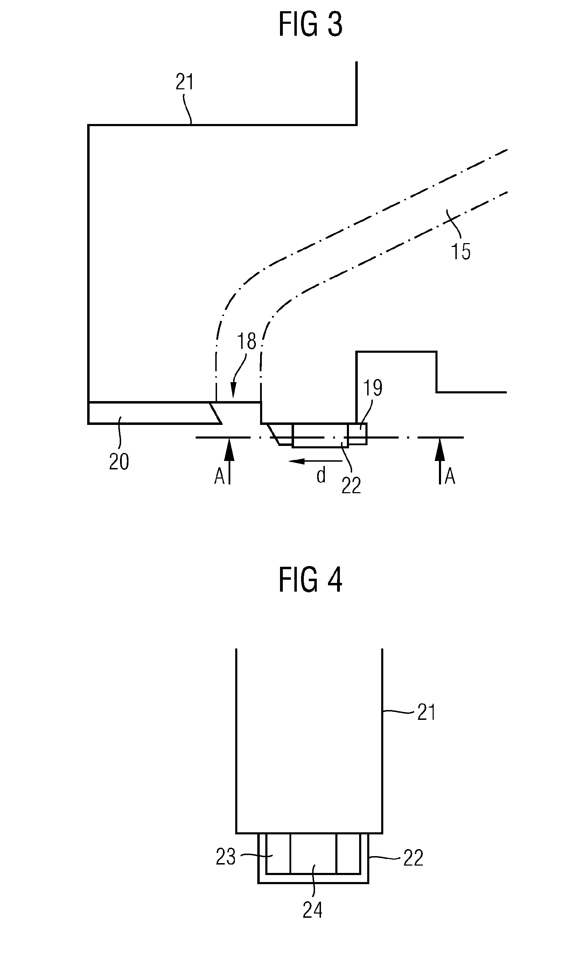

In Figur 3 ist der Austrittsbereich 18 der in Figur 2 dargestellten Zuführeinrichtung 5 vergrößert abgebildet. Der in Figur 3 durch strichpunktierte Linien angedeutete Transportweg 15 innerhalb der Zuführeinrichtung 5 endet in dem Austrittsbereich 18, aus dem der leere Bauteilgurt 13 (in Figur 3 nicht dargestellt) die Zuführeinrichtung 5 verlässt. Im Austrittsbereich 18 ist an der Außenseite des Gehäuses 21 der Zuführeinrichtung 5, in Figur 3 auf der rechten Seite des Austrittsbereichs 18, der in der Schneidrichtung (Pfeil d) beweglich gelagerte Schneidekörper 19 angeordnet. Der Schneidekörper 19 wird durch ein am Gehäuse 21 befestigtes Führungselement 22 in der Schneidrichtung geführt und ist darin derart in der Schneidrichtung verschiebbar, dass er mit dem Gegenschneidekörper 20 in Wechselwirkung treten kann, um einen die Zuführeinrichtung 5 verlassenden Bauteilgurt 13 zu durchzutrennen. Im Ausführungsbeispiel ist der Gegenschneidekörper 20 auf der gegenüberliegenden Seite des Austrittsbereichs 18, in Figur 3 auf der linken Seite des Austrittsbereichs 18, fest am Gehäuse 21 befestigt.

Anhand der Figuren 4, 5 und 6 wird die Lagerung des bewegbaren Schneidekörpers 19 näher erläutert.

In Figur 4 ist das an der Unterseite des Gehäuses 21 der Zuführeinrichtung 5 angebrachte Führungselement 22 von der Rückseite in Richtung der Schneidrichtung ohne Schneidekörper 19 dargestellt. Das Führungselement 22 ist als eine Art Führungshülse ausgebildet, welches an seiner dem Austrittsbereich 18 zugewandten Seite zwei innere Anschläge 23 aufweist. Ein mittlerer Durchgangsbereich 24 ist durchgehend frei ausgebildet.

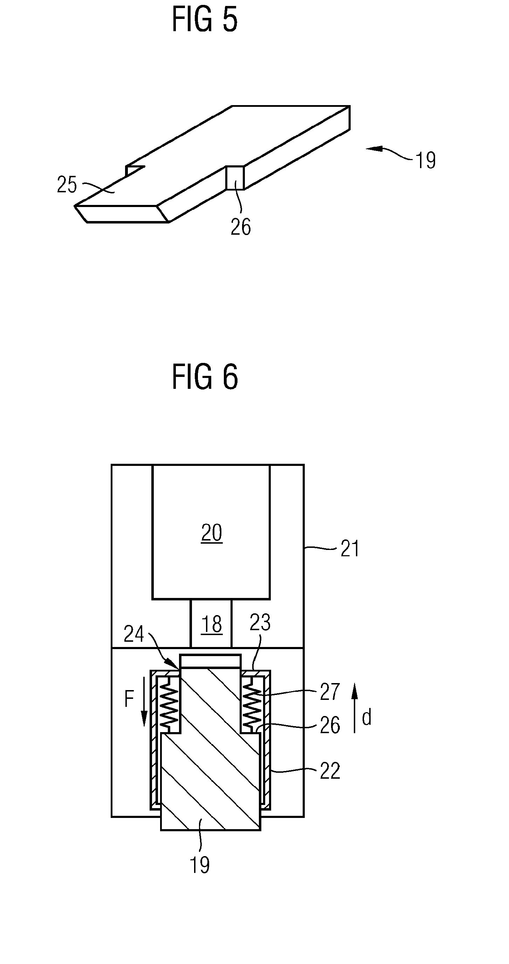

In das Führungselement 22 ist ein, in Figur 5 beispielhaft dargestellter Schneidekörper 19 einsetzbar, dessen Form an die innere Struktur des Führungselements 22 entsprechend angepasst ist. Ein schmaler vorderer Bereich 25 mit einer scharfen Schneidkante wird so in das Führungselement 22 eingesetzt, dass er den freien Durchgangsbereich 24 des Führungselements 22 durchdringen und auf der dem Austrittsbereich 18 zugewandten Seite des Führungselements 22 herausragen kann. In einem mittleren Bereich weist der Schneidekörper 19 zwei seitliche schulterartige Verbreiterungen 26 auf, welche gegen die Anschläge 23 des Führungselements 22 anstoßen und somit ein völliges Durchrutschen des Schneidekörpers 19 in Schneidrichtung verhindern.

Figur 6 ist eine schematische Ansicht des Austrittsbereichs 18 der Zuführeinrichtung 5 entlang der Schnittlinie A-A der Fig. 3. In Figur 6 ist der Gegenschneidekörper 20 oberhalb des Austrittsbereichs 18 angeordnet. Unterhalb des Austrittsbereichs 18 ist der in dem Führungselement 22 geführte bewegbare Schneidekörper 19 erkennbar. Zwischen den seitlichen Anschlägen 23 des Führungselements 22 und den schulterartigen Verbreiterungen 26 des Schneidekörpers 19 können Federelemente 27 eingesetzt werden, wobei die Federkraft F den Schneidekörper 19 entgegen der Schneidrichtung (Pfeil d) drückt. In dieser Ruheposition ist der Austrittsbereich 18 durch den Schneidekörper 19 nicht blockiert, so dass ein Bauteilgurt 13 frei entlang des Transportweges 15 transportiert werden kann.

Wie aus den Figuren 4, 5 und 6 hervorgeht, ist die Verschiebung des Schneidekörpers 19 im Führungselement 22 nur in Schneidrichtung durch die seitlichen Anschläge 23 begrenzt. Der Schneidekörper 19 kann jedoch entgegen der Schneidrichtung einfach aus dem Führungselement 22 herausgezogen werden. Da der Schneidekörper 19 im Ausführungsbeispiel außen am Gehäuse 21 der Zuführeinrichtung 5 angeordnet ist und deshalb leicht zugänglich ist, kann er im Falle, dass bestimmte Bauteilgurte 13 nicht geschnitten werden sollen, einfach aus dem Führungselement 22 entnommen werden.

In Figur 7 ist der Austrittsbereich 18 der Zuführeinrichtung 5 wieder vergrößert dargestellt, jedoch in einem Zustand, in dem die Zuführeinrichtung 5 am Bestückautomaten 2 gekoppelt ist. In Figur 7 ist die schon in Verbindung mit Figur 1 erwähnte Antriebsleiste 10 der Antriebseinrichtung 9, welche im Ausführungsbeispiel dem Bestückautomaten 2 zugeordnet ist, dargestellt. Die Antriebsleiste 10 kann durch einen später näher beschriebenen Antriebsmechanismus in der Schneidrichtung (Pfeil d) bewegt werden. Aus Figur 7 geht hervor, dass die Zuführeinrichtung 5 im angekoppelten Zustand eine Position einnimmt, in der die Antriebsleiste 10 und der bewegliche Schneidekörper 19 eine relative Lage zueinander einnehmen, so dass die Antriebsleiste 10 den Schneidekörper 19 im Führungselement 22 in Schneidrichtung bewegen kann. In Figur 7 steht die Antriebsleiste 10 jedoch nicht in Kontakt mit dem Schneidekörper 19, so dass dieser durch die Federelemente 27 (siehe Figur 6) in die Ruheposition gedrängt ist. Der andeutungsweise dargestellte Bauteilgurt 13 ist in dieser Ruheposition frei entlang des Transportweges 15 transportierbar.

In Figur 8 ist der Schneidekörper 19 durch die Antriebsleiste 10 in Schneiderichtung in eine Schneideposition verschoben dargestellt. In der Schneideposition überlappen sich der Gegenschneidekörper 20 und der bewegliche Schneidekörper 19 derart, dass der Bauteilgurt 13 durch Zusammenwirken der beiden scharfen Schneidkanten durchtrennt wird. Auf diese Weise wird der Bauteilgurt 13 sicher durchgeschnitten. Nach Beendigung des Schneidprozesses verfährt die Antriebsleiste 10 entgegen der Schneidrichtung (Pfeil e) und der Schneidekörper 19 wird durch die Federkraft wieder in die Ruheposition gedrängt. Der dadurch frei gewordene Austrittsbereich 18 ermöglicht den Weitertransport des Bauteilgurts 13.

Wie aus Figur 8 weiter deutlich wird, sind der bewegliche Schneidekörper 19 und der Gegenschneidekörper 20 derart entlang des Transportweges 15 an der Zuführeinrichtung 5 angeordnet, dass beim schrittweisen Vorschub der Bauteilgurt 13 immer zwischen den taschenartigen Vertiefungen 14 durchtrennt wird. In dem Fall, dass der bewegbare Schneidekörper 19, wie in Figur 8 gezeigt, am Austrittsbereich 18 angeordnet ist, wird dies durch eine entsprechende Auslegung der Länge des Transportwegs 15 erzielt, sodass die Schnittlinie des bewegbaren Schneidekörpers 19 bei jedem Stillstand des Bauteilgurts 13 immer zwischen den Vertiefungen liegt. Dadurch wird verhindert, dass, falls sich noch Bauteile in den taschenartigen Vertiefungen 14 befinden, diese nicht von dem bewegbaren Schneidkörper 19 getroffen werden. Somit wird einerseits die Schneidkante des Schneidekörpers 19 nicht beschädigt und andererseits ein Explodieren tantalhaltiger Bauteile vermieden.

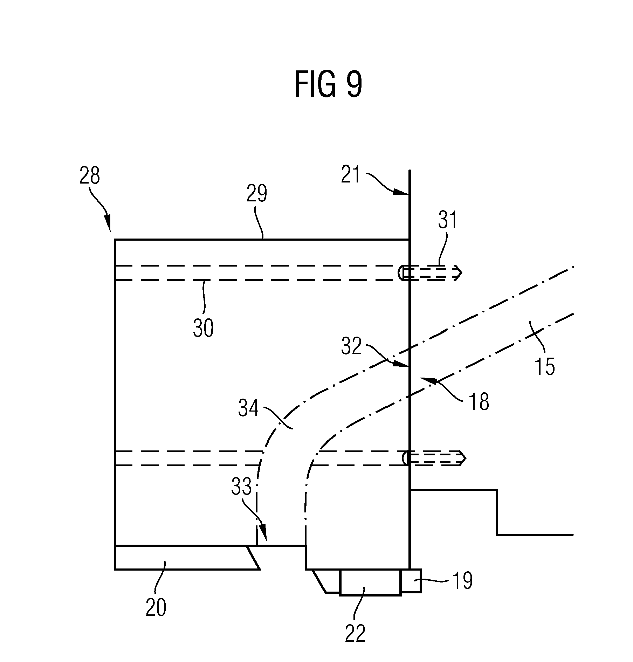

Im Folgenden wird eine erfindungsgemäße Schneidevorrichtung 28 zum lösbaren Anbringen an einer Zuführeinrichtung 5 für elektrische Bauteile anhand der Figur 9 näher erläutert. Auf der rechten Seite in Figur 9 ist der Teil einer Zuführeinrichtung 5 dargestellt, in dem sich der Austrittsbereich 18 für einen Bauteilgurt 13 befindet. Die Zuführeinrichtung 5 ist derart ausgestaltet, dass sie einen Bauteilgurt 13 mit taschenartigen Vertiefungen 14, in denen elektrische Bauteile gelagert sind, mittels eines entsprechenden Transportmechanismus 16 entlang eines Transportweges 15 in der Zuführeinrichtung 5 transportiert. Bezüglich des Transportmechanismus 16 und des Verlaufs des Bauteilgurts 13 entlang des Transportweges 15 in der Zuführeinrichtung 5 wird auf die Beschreibung der Figur 2 verwiesen. Wie aus Figur 8 ersichtlich ist, endet der durch strichpunktierte Linien angedeutete Transportweg 15 an einem Austrittsbereich 18 der Zuführeinrichtung 5, in dem ein leerer Bauteilgurt 13 die Zuführeinrichtung 5 verlassen kann.

Auf der linken Seite der Figur 9 ist ein Ausführungsbeispiel der erfindungsgemäßen Schneidevorrichtung 28 gezeigt. Die Schneidevorrichtung 28 verfügt über ein Schneidegehäuse 29, welches zwei Durchgangsbohrungen 30 aufweist, über welche das Schneidgehäuse 29, beispielsweise mittels zweier Schraubverbindungen 31, lösbar an der Zuführeinrichtung 5 befestigt ist. Das Schneidgehäuse 29 weist ferner eine Eintrittsöffnung 32 und eine Austrittsöffnung 33 auf, welche über einen durchgehenden, in dem Schneidgehäuse 29 verlaufenden Führungskanal 34 verbunden sind. Die Eintrittsöffnung 32, die Austrittsöffnung 33 und der Führungskanal 34 sind dabei so dimensioniert, dass ein Bauteilgurt 13 durch die Schneidevorrichtung 28 geführt werden kann. An einer Unterseite des Schneidgehäuses sind im Bereich der Austrittsöffnung 33 der bewegbare Schneidekörper 19 sowie der Gegenschneidekörper 20 angeordnet. Das Schneidgehäuse 29 ist derart an der Zuführeinrichtung 5 angebracht, dass der Führungskanal 34 eine Verlängerung des Transportweges 15 der Zuführeinrichtung 5 darstellt, so dass ein durch die Zuführeinrichtung 5 geführter Bauteilgurt 13, welcher die Zuführeinrichtung 5 im Austrittsbereich 18 verlässt, übergangslos durch den Führungskanal 34 der Schneidevorrichtung 28 weitergeführt wird, bis er diese durch die Austrittsöffnung 33 verlässt. Der bewegbare Schneidekörper 19 und der Gegenschneidekörper 20 dienen zum Durchtrennen des Bauteilgurts 13. Bezüglich der konstruktiven Ausgestaltung und der Funktionsweise des bewegbaren Schneidekörpers 19 und des Gegenschneidekörpers 20 wird auf die Beschreibung des vorhergehenden Ausführungsbeispiels verwiesen.

Vorteilhafterweise ist die Länge des Führungskanals 34 im Schneidgehäuse 29 derart dimensioniert, dass ein bestimmter Typ von Bauteilgurt 13, welcher einen vorgegebenen Abstand zwischen den Vertiefungen 14 aufweist und schubweise um eine klar definierte Strecke durch den Führungskanal 34 transportiert wird, immer genau zwischen den taschenartigen Vertiefungen 14 durchtrennt wird. Bezüglich der Vorteile dieser Ausgestaltung wird auf das oben beschriebene Ausführungsbeispiel verwiesen.

Dadurch, dass die erfindungsgemäße Schneidevorrichtung 28 als eigenständiges Bauteil lösbar an einer entsprechenden Zuführeinrichtung 5 anbringbar ist, sind auch Zuführeinrichtungen 5, welche über keine derartige Schneidevorrichtung 28 verfügen, einfach und schnell nachrüstbar. Ferner kann die Schneidevorrichtung 28 in dem Fall, dass ein Bauteilgurt 13 nicht geschnitten werden soll, mit wenigen Handgriffen von der Zuführeinrichtung 5 entfernt werden. Der bewegbare Schneidkörper muss aus diesem Grund nicht unbedingt, wie im vorigen Ausführungsbeispiel beschrieben, so ausgestaltet sein, dass es aus der Führungsschiene herausziehbar ist.

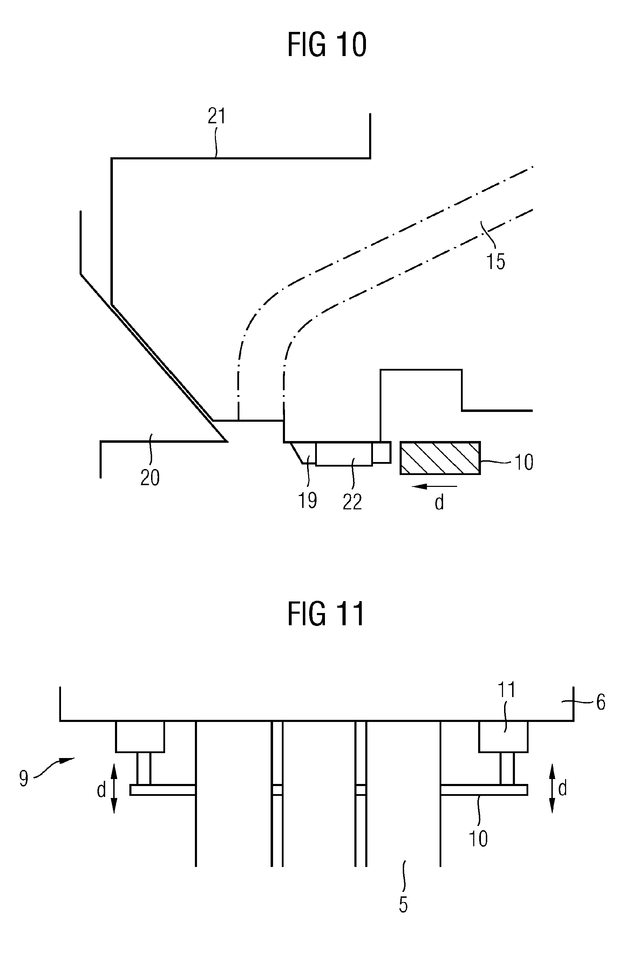

In Figur 10 ist eine weitere Ausgestaltung der erfindungsgemäßen Zuführeinrichtung 5 dargestellt. Sie unterscheidet sich von dem zuvor beschriebenen Ausführungsbeispiel der Zuführeinrichtung 5 dadurch, dass der Gegenschneidekörper 20 nun nicht der Zuführeinrichtung 5 zugeordnet ist, sondern Teil des Bestückautomaten 2 oder eines Transportwagens ist. In dem Zustand, in dem die Zuführeinrichtung 5 an den Transportwagen bzw. an den Bestückautomaten 2 gekoppelt ist, nehmen der Gegenschneidekörper 20 und der bewegbare Schneidekörper 19 eine relative Lage zueinander ein, so dass sie derart in Wechselwirkung treten können, dass bei Betätigung der Antriebseinrichtung 9 ein durch die Zuführeinrichtung 5 geführter Bauteilgurt 13 durchtrennt wird.

Analog zu diesem Ausführungsbeispiel für die Zuführeinrichtung 5 kann auch die erfindungsgemäße Schneidevorrichtung 28 entsprechend ausgestaltet sein. In diesem Fall befände sich nur der bewegbare Schneidekörper 19 an der Schneidevorrichtung 28, wogegen sich der Gegenschneidekörper 20 am Bestückautomaten 2 oder an einem Transportwagen befinden würde. Die Funktionsweise wäre analog zu der in Figur 10 gezeigten Ausgestaltung der Zuführeinrichtung 5.

In Figur 11 ist der Antriebsmechanismus für die Zuführeinrichtungen 5 bzw. für die Schneideinrichtungen an den Zuführeinrichtungen 5 als eine mögliche Ausführungsform dargestellt. Die Antriebseinrichtung 9 kann dabei entweder einem Bestückautomaten 2 oder auch einem Transportwagen, an welchem die Zuführeinrichtungen 5 jeweils koppelbar sind, zugeordnet sein. Im Falle der Figur 11 umfasst die Antriebseinrichtung 9 die zwei Aktuatoren 11 in Form zweier Pneumatikzylinder und die Antriebsleiste 10, welche sich quer über alle am Bestückautomat 2 bzw. an dem Transportwagen angekoppelten Zuführeinrichtungen 5 erstreckt. Die Aktuatoren 11 befinden sich an den Enden der Antriebsleiste 10. Durch die Pneumatikzylinder kann die Antriebsleiste 10 in der Schneidrichtung (Pfeil d) bewegt werden, um die bewegbaren Schneidekörper 19 der einzelnen Zuführeinrichtungen 5 bzw der Schneidvorrichtungen in die Schneidposition zu bringen und den Bauteilgurt 13 (in Fig. 11 nicht dargestellt) zu durchtrennen. Die Antriebseinrichtung 9 wird über entsprechende Leitungen mit Druckluft versorgt und ist über elektrische Leitungen, wie auch in Figur 1 dargestellt, mit einer Steuereinrichtung 12 verbunden, welche die Bewegung der Aktuatoren 11 steuert. Die Antriebseinrichtung 9 ist nicht auf einen pneumatischen Antrieb begrenzt. Auch ein entsprechender elektrisch betriebener Mechanismus ist denkbar.

Wie im Zusammenhang mit den oben dargestellten Ausführungsbeispielen erwähnt wurde, ist der bewegbare Schneidekörper 19 entlang des Transportweges 15 der Zuführeinrichtung 5 bzw. entlang des Führungskanals 34 der Schneidevorrichtung 28 derart angeordnet, dass die Bauteilgurte 13 immer zwischen den taschenartigen Vertiefungen 14 durchtrennt werden. In den konkreten Ausführungsbeispielen ist der bewegbare Schneidekörper 19 dabei immer außerhalb an der Zuführeinrichtung 5 bzw. außerhalb an dem Schneidgehäuse 29 der Schneidevorrichtung 28 angeordnet. Der Erfindungsgedanke schließt jedoch auch eine Lösung ein, bei der der Schneidekörper 19 innerhalb der Zuführeinrichtung 5 bzw. innerhalb des Schneidgehäuses angeordnet ist und über eine entsprechende mechanische Verbindung nach außen mit der Antriebseinrichtung 9 koppelbar ist.

In den Ausführungsbeispielen ist für die in einem Zuführbereich an dem Bestückautomat 2 gekoppelten Zuführeinrichtungen 5 nur eine einzige Antriebseinrichtung 9 vorgesehen. Die bewegbaren Schneidekörper 19 werden dabei nur durch diese eine Antriebsleiste 10 betätigt. Der Erfindungsgedanke erstreckt sich jedoch auch auf eine Ausgestaltung, bei der mehrere Antriebseinrichtungen vorgesehen sind, wobei jedoch die bewegbaren Schneidekörper 19 zumindest zweier Zuführeinrichtungen 5 bzw. Schneidvorrichtungen 28 durch jeweils eine Antriebseinrichtung 9 betätigt werden.

Alternativ erstreckt sich der Erfindungsgedanke auch auf eine Ausgestaltung, bei der am Bestückautomat für jede Zuführeinrichtung 5 eine individuelle Antriebseinrichtung vorgesehen ist. In diesem Fall kann das Schneiden der Bauteilgurte für jede Zuführeinrichtung individuell gesteuert werden.

In den Ausführungsbeispielen ist der Gegenschneidekörper 20 mit einer Schneidekante versehen. Der Erfindungsgedanke umfasst jedoch auch einen Gegenschneidekörper 20 ohne Schneidekante, beispielsweise in Form einer Schneideplatte.

Bezugszeichenliste:
- 1: Bestücksystem
- 2: Bestückautomat
- 3: Substrat
- 4: Transportstrecke
- 5: Zuführeinrichtung
- 6: Bestückkopf
- 7: Querträger
- 8: Längsträger
- 9: Antriebseinrichtung
- 10: Antriebsleiste
- 11: Aktuatoren
- 12: Steuereinrichtung
- 13: Bauteilgurt
- 14: Vertiefung
- 15: Transportweg
- 16: Transportmechanismus/Transportrad
- 17: Greifer
- 18: Austrittsbereich
- 19: Bewegbarer Schneidekörper
- 20: Gegenschneidekörper
- 21: Gehäuse der Zuführeinrichtung
- 22: Führungselement
- 23: Anschläge
- 24: Durchgangsbereich
- 25: Vorderer Bereich des Schneidekörpers
- 26: Verbreiterungen
- 27: Federelement
- 28: Schneidevorrichtung
- 29: Schneidegehäuse
- 30: Durchgangsbohrung
- 31: Schraubverbindung
- 32: Eintrittsöffnung
- 33: Austrittsöffnung
- 34: Führungskanal

## Patentansprüche

1. Zuführeinrichtung (5) zum Zuführen von in Vertiefungen (14) eines Bauteilgurts (13) gelagerten elektrischen Bauteilen für einen Bestückautomat (2), mit
- einem Transportmechanismus (16), mittels dem der Bauteilgurt (13) entlang eines Transportwegs (15) in der Zuführeinrichtung (5) transportierbar ist, und
- einem bewegbaren Schneidekörper (19) zum Durchtrennen des Bauteilgurts (13), welcher an einer Stelle entlang des Transportweges (15) angeordnet und mit einer externen Antriebseinrichtung (9) koppelbar ist, mittels welcher der bewegbare Schneidekörper (19) in einer Schneidrichtung in eine Schneideposition bewegbar ist, in der der bewegliche Schneidekörper (19) in Zusammenwirken mit einem Gegenschneidekörper (20) den Bauteilgurt (13) durchtrennt.

2. Zuführeinrichtung (5) nach Anspruch 1, wobei der Gegenschneidekörper (20) an der Zuführeinrichtung (5) befestigt ist.

3. Zuführeinrichtung (5) nach Anspruch 1, wobei der bewegbare Schneidekörper (19) derart an der Zuführeinrichtung (5) angeordnet ist, dass er in einem Zustand, in dem die Zuführeinrichtung an dem Bestückautomaten angekoppelt ist, dem Gegenschneidekörper gegenüber steht, sodass er zum Schneiden des Bauteilgurts mit diesem entsprechend in Wechselwirkung treten kann.

4. Zuführeinrichtung (5) nach einem der Ansprüche 1 bis 3, wobei die Antriebseinrichtung (9) dem Bestückautomat (2) zugeordnet ist und die Zuführeinrichtung (5) an den Bestückautomat (2) ankoppelbar ist.

5. Zuführeinrichtung (5) nach einem der Ansprüche 1 bis 4, wobei der bewegbare Schneidekörper (19) mittels eines Federelements (27) elastisch gelagert ist, welches den bewegbaren Schneidekörper (19) entgegen der Schneidrichtung in eine Ruheposition drängt, in der der Bauteilgurt (13) frei transportierbar ist.

6. Zuführeinrichtung (5) nach einem der Ansprüche 1 bis 5, mit einem Gehäuse (21), wobei zumindest der bewegbare Schneidekörper (19) abnehmbar am Gehäuse (21) angeordnet ist.

7. Zuführeinrichtung (5) nach Anspruch 6, mit einem am Gehäuse (21) befestigten Führungselement (22), welches den beweglichen Schneidekörpers (19) hält und in der Schneidrichtung führt, wobei das Führungselement (22) und der bewegliche Schneidekörper (19) derart ausgebildet sind, dass der bewegliche Schneidekörper (19) dem Führungselement (22) entnehmbar ist.

8. Zuführeinrichtung (5) nach einem der Ansprüche 1 bis 7, wobei der bewegliche Schneidekörper (19) derart angeordnet ist, dass er den Bauteilgurt (13) zwischen den Vertiefungen (14) durchtrennt.

9. Schneidevorrichtung (28) zum lösbaren Anbringen an eine Zuführeinrichtung (5) mit einem Transportmechanismus (16), mittels dem ein Bauteilgurt (13) mit Vertiefungen (14) zur Aufnahme von elektrischen Bauteilen entlang eines Transportwegs (15) in der Zuführeinrichtung (5) transportierbar ist, wobei die Schneidevorrichtung (28) aufweist:
- ein Schneidgehäuse (29) mit einer Eintrittsöffnung (32) und eine Austrittsöffnung (33), welche über einen durchgehenden, in dem Schneidgehäuse (29) verlaufenden Führungskanal (34) für den Bauteilgurt (13) miteinander verbunden sind,
- einen in einer Schneidrichtung bewegbaren Schneidekörper (19) und einen Gegenschneidekörper (20), welche an einer Stelle entlang des Führungskanals (34) angeordnet sind,
wobei
- die Schneidevorrichtung (28) an einem Austrittsbereich (18) der Zuführeinrichtung (5) derart anbringbar ist, dass der Führungskanal (34) eine Verlängerung des Transportwegs (15) darstellt, und
- der bewegbare Schneidekörper (19) mit einer externen Antriebseinrichtung (9) koppelbar ist, mittels welcher der bewegbare Schneidekörper (19) in der Schneidrichtung in eine Schneideposition bewegbar ist, in der der bewegliche Schneidekörper (19) in Zusammenwirken mit dem Gegenschneidekörper (20) den Bauteilgurt (13) durchtrennt.

10. Schneidevorrichtung (28) nach Anspruch 9, wobei der bewegliche Schneidekörper (19) und der Gegenschneidekörper (20) derart angeordnet sind, dass sie den Bauteilgurt (13) zwischen den Vertiefungen (14) durchtrennen.

11. Schneidevorrichtung (28) nach Anspruch 10, wobei
- der Gegenschneidekörper (20) und der bewegliche Schneidekörper (19) im Bereich der Austrittsöffnung (33) am Schneidgehäuse (29) angeordnet sind, und
- die Länge des Führungskanals (34) so dimensioniert ist, dass der bewegliche Schneidekörper (19) und der Gegenschneidekörper (20) den Bauteilgurt (13) zwischen den Vertiefungen (14) durchtrennen.

12. Zuführeinrichtung (5) mit
- einem Transportmechanismus (16), mittels dem ein Bauteilgurt (13) mit Vertiefungen (14) zur Aufnahme von elektrischen Bauteilen entlang eines Transportwegs (15) in der Zuführeinrichtung (5) transportierbar ist,
- einem Austrittsbereich (18) für den Bauteilgurt (13), und
- einer am Austrittsbereich (18) angebrachten Schneidevorrichtung (28) nach einem der Ansprüche 9 bis 11.

13. Bestückautomat (2) zum Bestücken von Substraten (3) mit elektrischen Bauteilen, wobei an den Bestückautomat (2) mehrere Zuführeinrichtungen (5) nach einem der Ansprüche 1 bis 8, 12 koppelbar sind und der Bestückautomat (3) mindestens eine Antriebseinrichtung (9) aufweist, mittels der der bewegliche Schneidekörper (19) zumindest einer der Zuführeinrichtungen (5) im angekoppelten Zustand bewegbar ist.

14. Bestückautomat (2) nach Anspruch 13, wobei die Antriebseinrichtung (9) derart ausgebildet ist, dass damit die bewegbaren Schneidekörper (19) mehrerer Zuführeinrichtungen (5) gemeinsam bewegbar sind.

15. Bestückautomat (2) nach Anspruch 14, wobei die Antriebseinrichtung (9) eine bewegbare Antriebsleiste (10) aufweist, mittels welcher die bewegbaren Schneidekörper (19) der Zuführeinrichtungen (5) gemeinsam bewegbar sind.

16. Bestückautomat (2) nach Anspruch 15, wobei der Bestückautomat (2) zwei Aktuatoren (11) zum Betätigen der Antriebsleiste (10) aufweist, wobei die Aktuatoren (11) jeweils an gegenüberliegenden Enden der Antriebsleiste (10) angeordnet sind.

17. Bestücksystem (1), mit einem Bestückautomat (2) nach einem der Ansprüche 13 bis 16 und mehreren Zuführeinrichtungen (5) nach einem der Ansprüche 1 bis 8, 12.
